# FASCICULE DE BREVET EUROPEEN

(11) **EP 2 337 094 B1**
(45) Date de publication et mention de la délivrance du brevet: **20.06.2012**
(21) Numéro de dépôt: 10195018.6
(22) Date de dépôt: 14.12.2010
(51) Int. Cl.: H01L 33/00, H01L 33/06, H01L 33/40, H01L 33/46

(54) **Source de photons résultants d'une recombinaison d'excitons localisés**
Eine auf Rekombination von lokalisierten Exzitonen basierende Photonquelle
Photon source based on localised exciton recombination

(30) Priorité: 15.12.2009 FR 0959007
(43) Date de publication de la demande: 22.06.2011
(73) Titulaire: Commissariat à l'Énergie Atomique et aux Énergies Alternatives, 75015 Paris (FR); Centre National de la Recherche Scientifique, 75794 Paris Cedex 16 (FR); STMicroelectronics (Grenoble 2) SAS, 38000 Grenoble (FR)
(72) Inventeur: Espiau de Lamaestre, Roch, 38000, Grenoble (FR); Greffet, Jean-Jacques, 91370, Verrieres le Buisson (FR); Guillaumot, Bernard, 38120, Le Fontanil (FR); Esteban Llorente, Ruben, 28232, Madrid (ES)
(74) Mandataire: de Beaumont, Michel

(56) Documents cités:
- US-A- 4 882 295
- US-A1- 2005 247 924
- CHRISTINA MANOLATOU ET AL: "Subwavelength Nanopatch Cavities for Semiconductor Plasmon Lasers", IEEE JOURNAL OF QUANTUM ELECTRONICS, IEEE SERVICE CENTER, PISCATAWAY, NJ, USA, vol. 44, no. 5, 1 mai 2008 (2008-05-01), pages 435-447, XP011205181, ISSN: 0018-9197

## Description

### Domaine de l'invention

La présente invention concerne des sources de photons comprenant au moins un émetteur susceptible d'être excité directement ou indirectement, et donc d'émettre un rayonnement, par injection successive de porteurs de types de polarité opposée (de manière à former un ou plusieurs excitons localisés). Ces sources de photons incluent les sources de photons à boîtes quantiques telles que celles comprenant des nanocristaux dans une couche isolante.

### Exposé de l'art antérieur

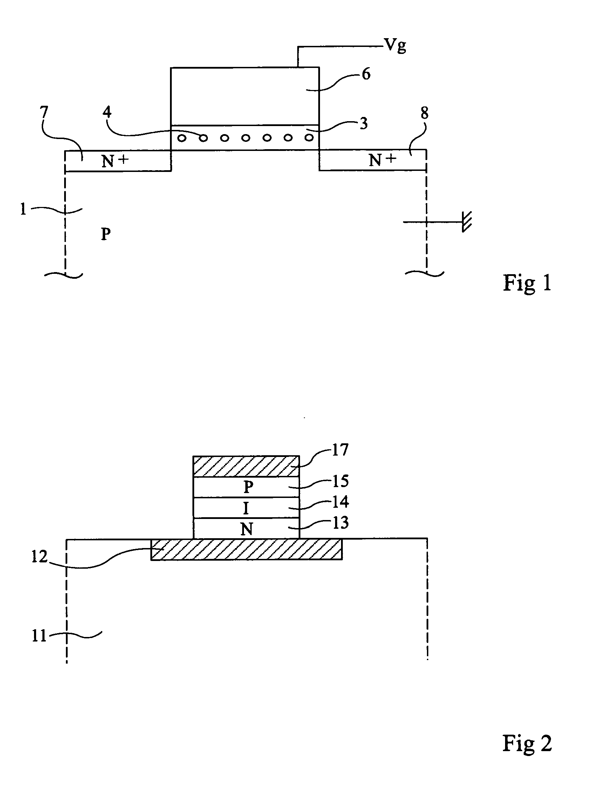

Un article de Robert J. Walters et al. intitulé "Silicon Nanocrystal Field-Effect Light-Emitting Devices" publié dans IEEE Journal of Selected Topics In Quantum Electronics, vol. 12, N° 6, novembre-décembre 2006, PP 1697-1656, décrit un dispositif photoémetteur à nanocristaux de silicium tel qu'illustré en figure 1. Ce dispositif comprend, sur un substrat massif 1 de silicium de type P, une grille comprenant une couche d'isolant de grille 3 incorporant des nanocristaux de silicium 4. Cet isolant de grille est surmonté d'une électrode de grille en silicium polycristallin 6 susceptible d'être mise à une tension Vg. Des régions de source et de drain 7 et 8 fortement dopées de type N⁺ sont disposées de part et d'autre de la grille pour constituer une structure qui ressemble à celle d'un transistor MOS à effet de champ à canal N (nMOSFET) classique. En fonctionnement, dans un premier état, la source et le drain sont polarisés pour que le composant soit passant et des électrons sont injectés via le canal par effet tunnel dans des nanocristaux 4. Dans un deuxième état, la source et le drain sont mis au même potentiel et des trous sont injectés par effet tunnel à partir du substrat dans les nanocristaux. Une fois qu'ils ont reçus un électron et un trou, les nanocristaux émettent de la lumière.

Cette source de lumière est très peu intense, d'abord fondamentalement parce que les nanocristaux de silicium sont des émetteurs peu efficaces, et d'autre part parce que la lumière une fois émise doit traverser le silicium polycristallin de grille avant de sortir vers l'extérieur.

La demande de brevet US 2005/0247924 A1 décrit un dispositif photoémetterur de ce type.

Un article de Christina Manolatou et al. intitulé "Subwavelength Nanopatch Cavities for Semiconductor Plasmon Lasers" publié dans IEEE Journal of Quantum Electronics, vol. 4 N°5, mai 2008, PP 435-447, décrit un autre type de structure de type diode contenant un milieu photoémetteur de type 111-V (et pas des nanocristaux constituant des boîtes quantiques). Dans cet article, les auteurs étudient le fonctionnement d'une diode photoémettrice PIN insérée dans une structure de type antenne patch. Cette structure est illustrée en figure 2. Sur un substrat 11 est disposée une première électrode métallique 12 surmontée d'une diode PIN comprenant une couche N 13, une couche intrinsèque 14 et une couche P 15, l'ensemble étant surmonté d'une autre électrode métallique 17. L'ensemble des deux électrodes constituant une structure de type antenne patch. Il est exposé que cette structure a, quand la diode émet, les caractéristiques d'une antenne patch et fournit un rayonnement directif. Dans tous les exemples donnés, l'ensemble des couches PIN a une épaisseur de l'ordre de 140 à 240 nm. De plus l'épaisseur de l'électrode métallique 17 est de l'ordre de 100 nm, ce qui la rend fortement opaque aux photons. Ainsi la cavité résonante formée entre les deux électrodes métalliques a une hauteur (une épaisseur) de l'ordre de la demi-longueur d'onde (dans le milieu compris entre les deux électrodes) de la lumière émise. Cette cavité a une finesse très importante, de l'ordre de 200, c'est-à-dire que la source émettra dans une très faible plage de longueurs d'onde. Par exemple, si on considère une longueur d'onde centrale de 800 nm, la cavité pourra émettre dans une plage de longueurs d'onde comprise entre 796 et 804 nm.

Un avantage de cette structure, incorporant un système de type antenne patch est que la lumière sortante n'a pas à traverser les couches supérieures de la photodiode mais sort latéralement, pour former, sous l'effet de l'antenne, un faisceau directif.

Un inconvénient de la structure de type antenne patch proposée dans l'article de C. Manolatou et al. est qu'elle ne convient a priori pas pour réaliser le renforcement de l'émission d'une structure de type à boîtes quantiques, étant donné que (1) le(s) émetteur(s) source de lumière dans une structure de type à boîtes quantiques ont inévitablement des dimensions différentes, et produisent de la lumière dans une bande spectrale relativement large, par exemple de 600 à 1000 nm dans le cas de nanocristaux de silicium, et que (2) la concentration de champ électromagnétique est faible au sein de la cavité. Ainsi, seul un petit nombre d'émetteurs pourrait être actif, et leur émission serait peu efficace.

### Résumé

Un objet d'un mode de réalisation de la présente invention est de pallier au moins certains des inconvénients des structures classiques à boîtes quantiques, notamment, d'augmenter le rendement d'émission, et d'éviter que la lumière émise doive traverser une électrode de grille absorbante avant d'être émise vers l'extérieur.

Un autre objet d'un mode de réalisation de la présente invention est de prévoir des procédés de fabrication d'une structure photoémettrice à boîtes quantiques compatible avec des technologies de type CMOS.

Ainsi, un mode de réalisation de la présente invention prévoit une source de photons résultants d'une recombinaison d'excitons localisés, comprenant une couche semiconductrice dont une partie centrale est encadrée de régions fortement dopées ; au-dessus de ladite partie centrale, une portion de couche contenant des éléments activables par excitons, revêtue d'une première métallisation ; et sous la couche semiconductrice, une deuxième métallisation plus étendue que la première métallisation. La distance entre les première et deuxième métallisations est de l'ordre de 10 à 60 nm ; et l'étendue latérale de la première métallisation est de l'ordre de λ0/10*nₑ à λ0/2*n, où λ0 est la longueur d'onde dans le vide de la lumière émise et ne est l'indice efficace du mode formé dans la cavité constituée par les deux métallisations.

Selon un mode de réalisation de la présente invention, l'étendue latérale de la deuxième métallisation est de l'ordre de λ0/10*nₑ à 10*λ0/n_{e.}

Selon un mode de réalisation de la présente invention, la source de photons est de type à boîtes quantiques.

Selon un mode de réalisation de la présente invention, la partie centrale a un niveau de dopage inférieur à 10¹⁹ at./cm³ et est encadrée de régions plus fortement dopées de types de conductivité opposés.

Selon un mode de réalisation de la présente invention, la couche semiconductrice est une couche de silicium.

Selon un mode de réalisation de la présente invention, l'épaisseur totale des couches comprises entre les deux électrodes est de 10 à 30 nm.

Selon un mode de réalisation de la présente invention, les boîtes quantiques sont des nanocristaux de silicium.

Selon un mode de réalisation de la présente invention, l'étendue latérale de la première métallisation est de l'ordre de 50 à 300 nm.

Selon un mode de réalisation de la présente invention, la source de photons comprend un premier moyen de connexion relié à la deuxième électrode et aux première et deuxième régions fortement dopées ; et un deuxième moyen de connexion relié à la première électrode.

Un mode de réalisation de la présente invention prévoit un procédé de fabrication d'une source de photons selon l'une quelconque des revendications 1 à 9, comprenant les étapes suivantes :
former au-dessus de la couche supérieure d'une structure de type SOI, un empilement de grille comprenant une région contenant des boîtes quantiques et une électrode métallique ;
implanter des régions fortement dopées N⁺ et P⁺ de part et d'autre de la grille ;
retourner la structure et former une métallisation de deuxième électrode ;
retourner à nouveau la structure et former des connexions vers chacune de la première métallisation, de la deuxième métallisation et des deux régions fortement dopées.

Selon un mode de réalisation de la présente invention, les métallisations sont en cuivre ou en aluminium.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue en coupe illustrant une structure telle que décrite dans l'article susmentionné de Walters et al. ;
la figure 2 est une vue en coupe illustrant une structure telle que décrite dans l'article susmentionné de Manolatou et al. ;
la figure 3 est une vue en coupe illustrant une structure selon un mode de réalisation de la présente invention ; et
les figures 4A à 4D sont des vues en coupe schématiques illustrant des étapes successives d'un mode de fabrication selon la présente invention d'une structure telle que décrite ici.

Comme cela est habituel dans le domaine de la représentation des circuits intégrés, les diverses figures ne sont pas tracées à l'échelle, les dimensions de certaines couches ayant été arbitrairement dilatées par souci de lisibilité.

### Description détaillée

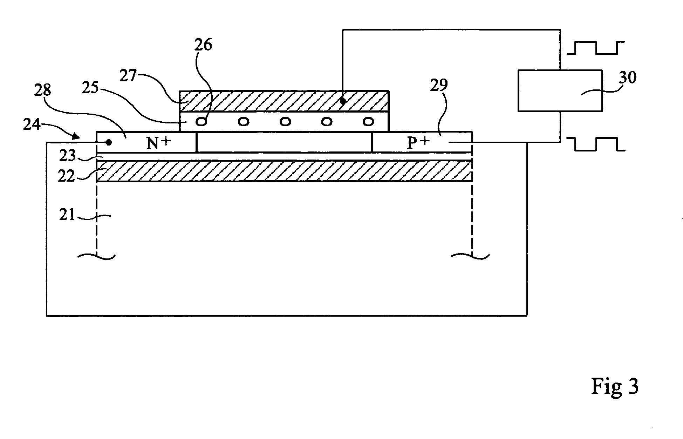

Comme l'illustre la figure 3, un mode de réalisation de la structure proposée ici comprend, sur un substrat 21, une première électrode métallique 22 surmontée d'une couche isolante 23 optionnelle au-dessus de laquelle est formée une couche semiconductrice 24. Sur la partie centrale de la couche semiconductrice 24, est formée une portion de couche en un matériau isolant 25 dans laquelle sont présents des nanocristaux 26 constituant des boîtes quantiques. La couche 25 peut aussi être en un matériau semiconducteur à bande interdite plus élevé que celle du matériau de la couche semiconductrice 24 (on parlera d'un matériau semiconducteur à grande bande interdite). La couche 25 est surmontée d'une deuxième électrode métallique 27. Des implantations sont réalisées de part et d'autre de la grille pour former, à gauche dans la figure, une région 28 fortement dopée de type N (N⁺) et, à droite, une région 29 fortement dopée de type P (P⁺). De préférence, comme cela est illustré, les régions fortement dopées 28 et 29 s'étendent partiellement sous la couche 25 et l'électrode métallique 27, typiquement de 5 nm, pour faciliter l'injection des porteurs et donc la quantité de lumière produite.

Les couches 23, 24, 25 sont extrêmement minces, de sorte que l'épaisseur entre les deux électrodes métalliques est de l'ordre de 10 à 60 nm et de préférence de 10 à 30 nm. Ainsi, cette épaisseur est nettement inférieure à la demi-longueur d'onde (dans le milieu comprenant l'ensemble des matériaux compris entre les deux électrodes) de la lumière susceptible d'être émise par les nanocristaux. Cette faible épaisseur permet la concentration de champ électromagnétique au niveau des émetteurs placés dans la couche 25, et par conséquent le renforcement de leur émission. La concentration de champ obtenue par la structure est beaucoup plus importante que celle atteinte dans une cavité Fabry Perot verticale.

L'électrode supérieure 27 est aussi très mince (typiquement de l'ordre de quelques dizaines de nanomètres), ce qui lui permet de jouer le rôle de nappe de courant rayonnante lorsque l'émetteur est placé à proximité.

Par contre, l'étendue latérale de l'électrode supérieure 27 est de l'ordre de la demi-longueur d'onde (ou un multiple de celle-ci) dans le matériau considéré (λ0/2*nₑ), où λ0 est la longueur d'onde dans le vide de la lumière émise et ne est l'indice efficace pour l'ensemble des couches 23 à 25.

Ainsi, dans le dispositif de la figure 3, il n'existe pas de cavité résonnante verticale de type Fabry-Pérot, mais une structure de cavité résonante principalement horizontalement grâce au couplage des champs proches électromagnétiques au voisinage des électrodes métalliques opposées. L'électrode inférieure 22 a une étendue latérale supérieure à celle de l'élément supérieur 27.

L'ensemble des deux électrodes 22, 27 fournit une structure de type antenne patch et le faisceau émis par les nanocristaux sera dirigé avec une certaine directivité, selon un ou deux lobes, de façon similaire à ce qui se produit dans des antennes micro-ondes de type patch. Cette directivité pourra être ajustée, en particulier par la taille latérale des électrodes 22 et 27.

Du fait que l'on n'a pas de cavité résonante verticale de type Fabry-Pérot entre les deux métallisations et que l'on utilise des modes électromagnétiques présentant un champ électromagnétique non négligeable dans le métal des électrodes 22 et 27, le facteur de qualité de la cavité sera relativement faible, de l'ordre de 3 à 10 d'après les expériences et les simulations effectuées par les inventeurs. Grâce à cela, on pourra émettre sur une relativement grande plage de longueurs d'onde, par exemple de l'ordre de 600 à 1000 nm, plus couramment de l'ordre de 700 à 900 nm.

Ainsi, on retrouve avec la structure décrite ici, les avantages d'une structure à antenne patch, dans laquelle la lumière est en fait extraite et réorientée grâce à la forme de l'antenne.

On notera que le mode de réalisation décrit ici ne correspond pas à une structure MOSFET classique et que les régions 28 et 29 disposées de part et d'autre de la grille sont de types de conductivité opposés. L'électrode inférieure 22 et les régions 28 et 29 sont connectées à une première borne d'une source d'alimentation en créneaux 30, alors que la grille (deuxième électrode 27) est connectée à l'autre électrode de l'alimentation 30. Si on fait varier alternativement la polarité de ces deux électrodes, on injectera alternativement des électrons à partir de la région N⁺ et des trous à partir de la région P⁺.

Bien que la réalisation illustrée en figure 3 et décrite ci-dessus constitue un mode de réalisation préféré, on pourra aussi utiliser, bien que cela semble moins efficace du point de vue de l'injection des porteurs, une structure de type MOSFET telle que celle illustrée en figure 1, les électrons étant fournis par les régions de drain et de source et les trous par la région centrale. Dans ce cas également, on prévoira de préférence une pénétration partielle des régions fortement dopées (de même type de conductivité) sous la grille. On pourra aussi utiliser, bien que cela soit moins efficace du point de vue de l'injection électrique, une structure dans laquelle les électrons sont fournis par une région fortement dopée N (N+) et les trous par une région dopée de type P recouverte partiellement par l'électrode 27. On prévoira là aussi une pénétration partielle de la région N+ sous la grille 27.

De façon souhaitable, les émetteurs (les nanocristaux ou boîtes quantiques 26) seront disposés plus près de la couche semiconductrice 24 que de la grille supérieure 27, pour faciliter l'injection de porteurs dans ces boîtes quantiques par effet tunnel et limiter les courants de fuite dans l'électrode 27.

La structure décrite ici présente notamment les avantages suivantes :
- puissance émise plus importante que celle d'une structure du type de la figure 1, ajustable par l'épaisseur de la cavité et la fréquence de pompage électrique,
- large bande spectrale de la cavité photonique,
- utilisation d'une antenne de type patch pour le contrôle de l'injection électrique, pour le renforcement du champ électromagnétique, et pour le contrôle de la directivité de l'émission,
- technologie compatible avec des techniques de fabrication CMOS, et
- possibilité d'utilisation d'une faible tension d'injection grâce à la structure P⁺-N⁺ utilisée.

### Exemple de procédé de fabrication

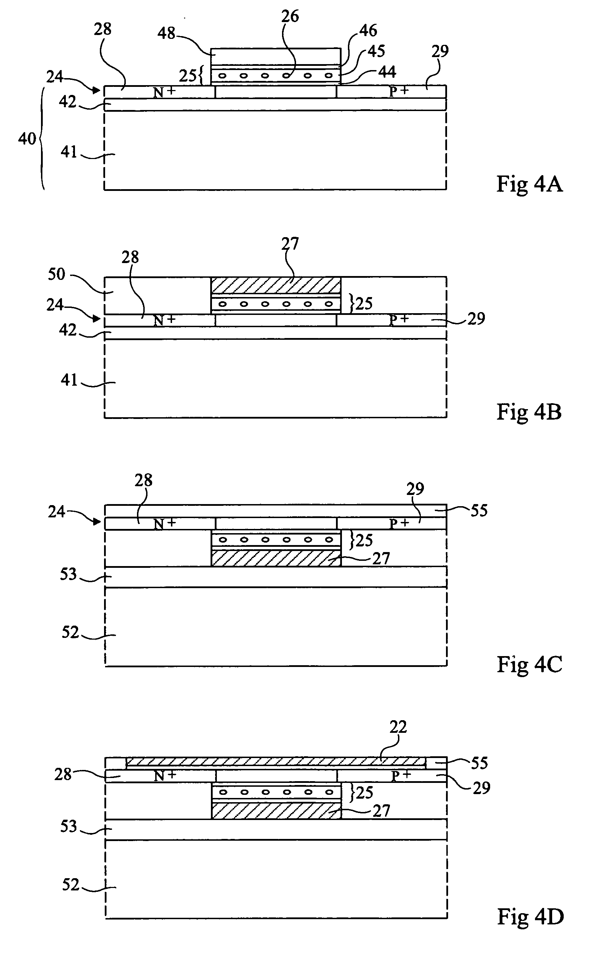

Les figures 4A à 4D illustrent des étapes d'un procédé de fabrication possible d'une structure selon la présente invention. Cet exemple constitue un aspect de la présente invention mais ne doit pas être considéré comme limitatif, d'autres procédés pouvant être envisagés pour obtenir la structure décrite en relation avec la figure 3.

Dans les figures 4A à 4D, on a utilisé pour les parties de couche correspondant à la structure finale, les mêmes références que celles utilisées en relation avec la figure 3.

La figure 4A représente la structure à une étape intermédiaire de fabrication. On part d'un substrat 40 de type SOI, comprenant sur une plaquette de silicium 41, une couche isolante 42 et une couche semiconductrice 24 d'un dopage inférieur à 10¹⁹ at./cm³ ayant de préférence une épaisseur de l'ordre de 10 nm. Dans la couche semiconductrice 24 sont formées par implantation des régions N⁺ et P⁺ 28 et 29 plus fortement dopées que la couche 24, après formation d'une grille isolée. Cette grille comprend par exemple une couche très mince (quelques nm) d'un matériau isolant 44, couramment de l'oxyde de silicium, une couche isolante 45 contenant des nanocristaux de silicium 26, ayant par exemple une épaisseur de 5 à 10 nm, et une couche isolante 46 ayant par exemple une épaisseur de 5 à 10 nm. L'ensemble des couches 44, 45 et 46 constitue la couche 25 décrite précédemment. La grille est revêtue d'une couche sacrificielle 48, par exemple en silicium polycristallin.

A une étape ultérieure de fabrication représentée en figure 4B, on a revêtu la structure d'une couche isolante 50, planarisée jusqu'à faire apparaître la couche de silicium polycristallin 48. Cette couche de silicium polycristallin a été éliminée par gravure sélective et remplacée selon un procédé damascène par une couche d'un métal, tel que le cuivre ou l'aluminium, qui va constituer la deuxième électrode 27 décrite précédemment.

Ensuite, comme l'illustre la figure 4C, la structure est retournée et collée sur une poignée 52, par exemple une tranche de silicium, avec interposition d'une couche d'oxyde 53. La face supérieure de la structure est recouverte d'une couche isolante 55. Cette couche isolante 55 peut correspondre à une partie de l'épaisseur de la couche d'oxyde 42 de la structure SOI initiale.

A l'étape illustrée en figure 4D, on a creusé la couche d'oxyde supérieure 55, et on a rempli par un procédé damascène la partie creusée d'un métal tel que du cuivre ou de l'aluminium, pour former la première électrode 22 de la structure de la figure 3.

Après cela, on pourra retourner à nouveau la structure, la fixer à une poignée (une plaquette de silicium), éliminer la première poignée 52, et réaliser des contacts vers la première électrode 22, la deuxième électrode 27, et les régions N⁺ et P⁺ 28 et 29.

La présente invention est susceptible de nombreuses variantes et modifications qui apparaîtront à l'homme de l'art, notamment en ce qui concerne le procédé de fabrication et les matériaux constitutifs des diverses couches isolantes et métalliques ainsi que l'utilisation de diverses couches d'arrêt de gravure et de diverses couches barrières de diffusion. De plus, bien que l'on ait décrit une couche semiconductrice 24 en silicium, on comprendra que tout autre matériau semiconducteur pourrait être utilisé à condition que sa bande interdite soit inférieure à celle de la couche 25.

Des modes de réalisation de la présente invention ont été décrits dans le cas de structures à boîtes quantiques constituées de nanocristaux de silicium noyés dans une couche isolante. D'autres types de nanocristaux pourront être utilisés, par exemple des nanocristaux de CdS, de CdSe, de CdTe, de PbS, de PbSe, de PbTe, de Ge et de matériaux III-V (AsGa, InGaAs, InAs, GaSb, InSb...). On pourra aussi utiliser des îlots de semiconducteurs obtenus par croissance sur des substrats semiconducteurs désaccordés tels que des îlots de matériau III-V comme GaN sur substrat AlN, InAs sur substrat GaAs, InAs sur substrat InP... La nature et la taille des boîtes quantiques détermineront la longueur d'onde d'émission et donc le dimensionnement de la structure.

De façon plus générale la présente invention s'applique à toute structure dans laquelle une singularité de potentiel électrostatique constitue un émetteur susceptible d'être excité directement ou indirectement, et donc d'émettre un rayonnement, par injection de porteurs de types de polarité opposés (formation d'un ou plusieurs excitons). Cette singularité peut correspondre à un défaut cristallin tel qu'une lacune dans un cristal, par exemple un centre F dans un cristal d'halogénure d'alcalin (NaCl, KCl, NaBr, KBr). On pourra également prévoir que l'émission de lumière provienne de terres rares, par exemple de l'erbium inclus dans un oxyde par implantation ou de l'erbium ou Yb dans du CdTe dopé. Ainsi la présente invention concerne toute source de photons résultant d'une recombinaison d'excitons localisés.

De plus, on notera que la structure décrite peut avantageusement constituer une source dite de photon unique pouvant fonctionner à fréquence élevée (plusieurs mégahertz).

## Revendications

1. Source de photons résultants d'une recombinaison d'excitons localisés, comprenant :
une couche semiconductrice (24) dont une partie centrale est encadrée de régions (28, 29) fortement dopées ;
au-dessus de ladite partie centrale, une portion de couche (25) contenant des éléments activables par excitons (26), revêtue d'une première métallisation (27) ; et
sous la couche semiconductrice, une deuxième métallisation (22) plus étendue que la première métallisation (27) ; dans laquelle :
la distance entre les première et deuxième métallisations est de l'ordre de 10 à 60 nm ; et
l'étendue latérale de la première métallisation est de l'ordre de λ0/10*nₑ à λ0/2*nₑ, où λ0 est la longueur d'onde dans le vide de la lumière émise et ne est l'indice efficace du mode formé dans la cavité constituée par les deux métallisations.

2. Source de photons selon la revendication 1, dans laquelle l'étendue latérale de la deuxième métallisation est de l'ordre de λ0/10*nₑ à 10*λ0/nₑ.

3. Source de photons selon la revendication 1 ou 2, de type à boîtes quantiques.

4. Source de photons selon l'une quelconque des revendications 1 à 3, dans laquelle ladite partie centrale a un niveau de dopage inférieur à 10¹⁹ at./cm³ et est encadrée de régions (28, 29) plus fortement dopées de types de conductivité opposés.

5. Source de photons selon l'une quelconque des revendications 1 à 4, dans laquelle la couche semiconductrice (24) est une couche de silicium.

6. Source de photons selon l'une quelconque des revendications 1 à 5, dans laquelle l'épaisseur totale des couches comprises entre les deux électrodes est de 10 à 30 nm.

7. Source de photons selon l'une quelconque des revendications 1 à 6, dans laquelle les boîtes quantiques sont des nanocristaux de silicium.

8. Source de photons selon la revendication 7, dans laquelle l'étendue latérale de la première métallisation est de l'ordre de 50 à 300 nm.

9. Source de photons selon l'une quelconque des revendications 1 à 8, comprenant :
un premier moyen de connexion relié à la deuxième électrode et aux première et deuxième régions fortement dopées ; et
un deuxième moyen de connexion relié à la première électrode.

10. Procédé de fabrication d'une source de photons selon l'une quelconque des revendications 1 à 9, comprenant les étapes suivantes :
former au-dessus de la couche supérieure (24) d'une structure de type SOI, un empilement de grille comprenant une région (25) contenant des boîtes quantiques (26) et une électrode métallique (27) ;
implanter des régions fortement dopées N⁺ (28) et P⁺ (29) de part et d'autre de la grille ;
retourner la structure et former une métallisation de deuxième électrode (22) ;
retourner à nouveau la structure et former des connexions vers chacune de la première métallisation, de la deuxième métallisation et des deux régions fortement dopées.

11. Procédé selon la revendication 10, dans lequel les métallisations sont en cuivre ou en aluminium.

## Claims

1. A source of photons resulting from a recombination of localized excitons, comprising:
a semiconductor layer (24) having a central portion surrounded with heavily-doped regions (28, 29);
above said central portion, a layer portion (25) containing elements capable of being activated by excitons (26), coated with a first metallization (27); and
under the semiconductor layer, a second metallization (22) of greater extension than the first metallization (27); wherein:
the distance between the first and second metallizations is on the order of from 10 to 60 nm; and
the lateral extension of the first metallization is on the order of from λ0/10*nₑ to λ0/2*nₑ, where λ0 is the wavelength in vacuum of the emitted light and nₑ is the effective refractive index of the mode formed in the cavity created by the two metallizations.

2. The photon source of claim 1, wherein the lateral extension of the second metallization is on the order of from λ0/10*nₑ to 10* λ0/nₑ.

3. The photon source of claim 1 or 2, of the type comprising quantum boxes.

4. The photon source of any of claims 1 to 3, wherein said central portion has a doping level lower than 10¹⁹ at./cm³ and is surrounded with more heavily-doped regions (28, 29) of opposite conductivity types.

5. The photon source of any of claims 1 to 4, wherein the semiconductor layer (24) is a silicon layer.

6. The photon source of any of claims 1 to 5, wherein the total thickness of the layers present between the two electrodes ranges from 10 to 30 nm.

7. The photon source of any of claims 1 to 6, wherein the quantum boxes are silicon nanocrystals.

8. The photon source of claim 7, wherein the lateral extension of the first metallization is on the order of from 50 to 300 nm.

9. The photon source of any of claims 1 to 8, comprising:
first connection means connected to the second electrode and to the first and second heavily-doped regions; and
second connection means connected to the first electrode.

10. A method for manufacturing a photon source according to any of claims 1 to 9, comprising the steps of:
forming above the upper layer (24) of an SOI-type structure a gate stacking comprising a region (25) containing quantum boxes (26) and a metal electrode (27);
implanting heavily-doped N⁺ (28) and P⁺ (29) type regions on either side of the gate;
flipping over the structure and forming a second electrode metallization (22);
flipping back the structure and forming connections towards each of the first metallization, of the second metallization, and of the two heavily-doped regions.

11. The method of claim 10, wherein the metallizations are made of copper or of aluminum.

## Patentansprüche

1. Eine auf Rekombination von lokalisierten Exzitonen basierende Photonenquelle, die Folgendes aufweist:
eine Halbleiterschicht (24) mit einem Mittelteil umgeben von stark dotierten Zonen (28, 29);
oberhalb des erwähnten Mittelteils einen Schichtteil (25), der Elemente enthält, die in der Lage sind, durch Exzitonen (26) aktiviert zu werden, und zwar beschichtet mit einer ersten Metallisierung (27);
unter der Halbleiterschicht eine zweite Metallisierung (22) mit einer größeren Erstreckung als die erste Metallisierung (27);
wobei:
der Abstand zwischen den ersten und zweiten Metallisierungen in der Größenordnung von 10 bis 60 nm liegt; und
die seitliche Erstreckung der ersten Metallisierung in der Größenordnung von λ0/10*nₑ bis λ0/2*nₑ ist, wobei λ0 die Wellenlänge des emittierten Lichts im Vakuum ist und nₑ der effektive Brechungsindex, der in dem Hohlraum durch die zwei Metallisierungen gebildeten Mode ist.

2. Die Photonenquelle nach Anspruch 1, wobei die seitliche Erstreckung der zweiten Metallisierung in der Größenordnung von λ0/10*nₑ bis 10*λ0/nₑ ist.

3. Die Photonenquelle nach Anspruch 1 oder 2, die von der Bauart die Quantumboxen aufweist ist.

4. Die Photonenquelle nach einem der Ansprüche 1 bis 3, wobei der Mittelteil einen Dotierpegel besitzt, der niedriger als 10¹⁹ at/cm³ ist, und umgeben ist mit noch stärker dotierten Zonen (28, 29) der entgegengesetzten Leitfähigkeitstypen.

5. Die Photonenquelle nach irgendeinem der Ansprüche 1 bis 4, wobei die Halbleiterschicht (24) eine Siliziumschicht ist.

6. Die Photonenquelle nach irgendeinem der Ansprüche 1 bis 5, wobei die Gesamtdicke der zwischen den zwei Elektroden vorhandenen Schichten in Bereichen von 10 bis 30 nm liegt.

7. Die Photonenquelle nach irgendeinem der Ansprüche 1 bis 6, wobei die Quantumboxen Silizium-Nanokristalle sind.

8. Die Photonenquelle nach Anspruch 7, wobei die seitliche Erstreckung der ersten Metallisierung in der Größenordnung von 50 bis 300 nm ist.

9. Die Photonenquelle nach einem der Ansprüche 1 bis 8, wobei Folgendes vorgesehen ist:
erste Verbindungsmittel, die mit der zweiten Elektrode und mit den ersten und zweiten stark dotierten Zonen verbunden sind; und
zweite Verbindungsmittel, die mit der ersten Elektrode verbunden sind.

10. Ein Verfahren zur Herstellung einer Photonenquelle nach einem der Ansprüche 1 bis 9, wobei die folgenden Schritte vorgesehen sind:
Formen oberhalb der oberen Schicht (24) einer SOI-Typstruktur einer Gate-Stapelung, die eine Zone (25) aufweist, die Quantumboxen (26) und eine Metallelektrode (27) enthält;
Implantieren auf jeder Seite des Gatters von stark dotierten N⁺ (28) und P⁺ (29) Typzonen;
Umdrehen der Struktur und bilden einer zweiten Elektrodenmetallisierung (22);
Zurückdrehen der Struktur und Bilden von Verbindungen zu jeder der ersten Metallisierung, der zweiten Metallisierung und der zwei stark dotierten Zonen.

11. Das Verfahren nach Anspruch 10, wobei die Metallisierungen aus Kupfer oder Aluminium hergestellt sind.
